# EUROPEAN PATENT SPECIFICATION

(11) **EP 0 390 607 B1**
(45) Date of publication and mention of the grant of the patent: **07.01.1998**
(21) Application number: 90303479.1
(22) Date of filing: 30.03.1990
(51) Int. Cl.: H01L 21/20, C30B 1/02

(54) **Process for forming crystalline semiconductor film**
Verfahren zur Herstellung eines halbleitenden kristallinen Filmes
Procédé de formation d'un film semi-conducteur cristallin

(30) Priority: 31.03.1989 JP 81103/89; 28.04.1989 JP 110386/89
(43) Date of publication of application: 03.10.1990
(73) Proprietor: CANON KABUSHIKI KAISHA, Tokyo (JP)
(72) Inventor: Sato, Nobuhiko, Atsugi-shi, Kanagawa-ken (JP); Yonehara, Takao, Atsugi-shi, Kanagawa-ken (JP); Kumomi, Hideya, Tokyo (JP)
(74) Representative: Beresford, Keith Denis Lewis

(56) References cited:
- EP-A- 0 308 166
- PATENT ABSTRACTS OF JAPAN, vol. 8, no. 4 (E-220)[1441], 10th January 1984; & JP-A-58 169 905 (HITACHI SEISAKUSHO K.K.) 06-10-1983
- PATENT ABSTRACTS OF JAPAN, vol. 7, no. 178 (E-191)[1323], 6th August 1983; & JP-A-58 085 520 (SHARP K.K.) 21-05-1983
- JOURNAL OF THE ELECTROCHEMICAL SOCIETY, vol. 134, no. 10, October 1987, pages 2536-2540; M.K. HATALIS et al.: "Solid phase epitaxy of LPCVD amorphous silicon films"
- Patent abstracts of Japan, vol. 13, no.68, (E-716)[3416], 16th February 1989; & JP-A-63 253 616

## Description

This invention relates to a process for forming a polycrystalline semiconductor film and more particularly to a process for forming polycrystalline semiconductor film with a large grain size and controlled grain boundary positions, suitable for forming thin film transistors (TFT's) of high performance.

Heretofore, processes for solid phase growth of a crystalline film performed by annealing an amorphous thin film preformed on a substrate at a lower temperature than the melting point have been proposed as processes to grow a crystalline film on a substrate such as an amorphous substrate, etc. For example, a process for formation of crystal by annealing an amorphous Si film having a thickness of about 100 nm formed on the surface of amorphous Si0₂ in a N₂ atmosphere at 600°C, thereby crystallising the amorphous Si thin film to obtain a polycrystalline film having grain sizes of about 5 µm is reported [T. Noguchi, H. Hayashi and H. Ohshima, 1987, Mat. Res. Soc. Symp. Proc., 106, Polysilicon and Interfaces, 293 (Elsevier Science Publishing, New York 1988)]. Since the surface of the polycrystalline film obtained by the process remains flat, it is possible to form electronic devices such as MOS transistors or diodes thereon. Furthermore, the average grain sizes of the polycrystalline film are larger than those of ordinary polycrystalline film obtained by the LPCVD process, thus the devices formed in such polycrystalline film have a relatively high performance.

In an alternative process described in European Patent Application EP-A-0308166, large grain-size polycrystalline silicon film is grown on a glass substrate by a process in which the interface between the glass substrate and an "as-deposited" amorphous silicon film is disrupted by deep implantation of Si⁺ ions prior to annealing.

However, although polycrystalline film obtained by either of the above-mentioned processes has relatively large crystal grain sizes, the distribution of grain sizes and the positions of crystal grain boundaries are not controlled, because the crystallisation of amorphous Si film is based on solid phase growth of crystal nuclei generated at random in the amorphous Si film during annealing. That is, generation of crystal nuclei at random leads to random positioning of grain boundaries, resulting in distribution of grain sizes in a broad range. In spite of merely large average crystal grain size, the above-mentioned process still has the following problems.

For example, in the case of MOS transistors, generally the gate size is as large as or less than the average crystal grain size and thus the gate region has a part containing no grain boundary and a part containing a few crystal grains. Electrical characteristics naturally change between the part containing no grain boundary and the part containing a few crystal grains. Thus, a large fluctuation develops in the characteristics between a plurality of devices, and when an integrated circuit, for example, is to be formed, the fluctuation in crystal grain size has been a considerable bar to consistent improvement of integrated circuit performance.

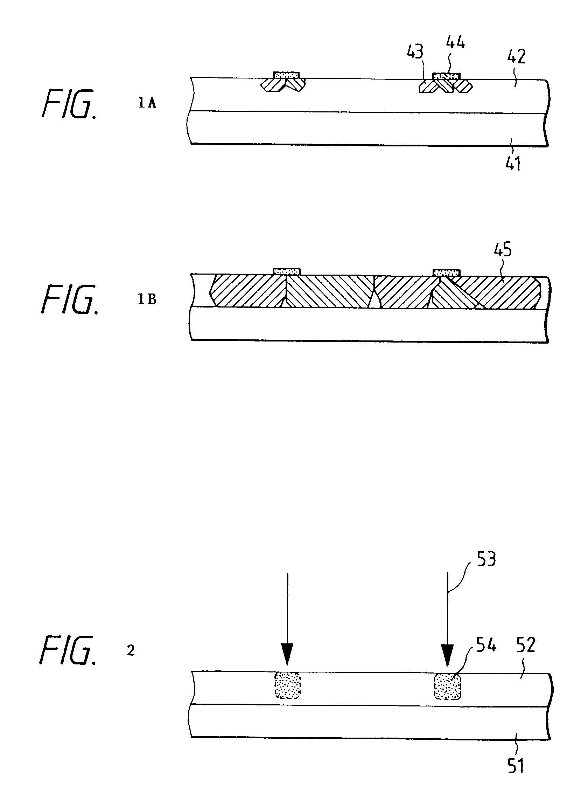

A process for reducing fluctuation in the grain size is proposed in Japanese Patent Application Kokai (Laid-Open) No. 58-56406, as will be explained below, referring is Fig. 1. As shown in Fig. 1A, an amorphous Si film 42 is formed on a substrate 41 of Si single crystal having a heat oxidation film on its surface. Then, thin film pieces 44 of a different material from that of the amorphous Si film 42, for example, Si0₂, are provided at regular intervals on the amorphous Si film. Then, the entire substrate is annealed in an ordinary heating furnace, whereby crystal nuclei 43 are preferentially formed at positions of the amorphous Si film 42 in contact with the peripheral parts of thin film pieces 44. By making the crystal nuclei grow further, the amorphous Si film 42 is crystallised throughout the entire volume, and a polycrystalline film composed of a group of crystal grains 45 with larger grain size, as shown in Fig. 1B can be obtained.

However, it is the current situation that the positions of crystal grain boundaries are not satisfactorily controlled even by the above-mentioned process, because in the above-mentioned process preferential formation of nuclei 43 takes place at the peripheral parts of the thin film pieces 44 due to local effects of elastic energy at the positions of the amorphous Si film 42 in contact with the peripheral parts of the thin film pieces 44. Consequently, a plurality of nuclei generate along the peripheral parts, but it is difficult to control the number of nuclei.

Furthermore, in order to obtain a polycrystalline film in the above-mentioned process, annealing is carried out after the thin film pieces 44 of a different material from that of amorphous Si film 42 are brought into contact with the amorphous Si film 42, and this procedure sometimes leads to contamination of the polycrystalline film with the constituent elements of thin film pieces 44 as impurity, which is a problem in the production of a polycrystalline film of high quality.

Control of positions for formation of nuclei in the solid phase growth of amorphous Si film is also proposed in Japanese Patent Application publication No. 63-253616, as will be explained below, referring to Fig. 2. N⁺ ions 53 are locally implanted in an amorphous Si thin film 52 on an insulating substrate 51 to form ion-implanted regions 54. Then, crystal nuclei are preferentially generated in other region than the ion-implanted regions 54, that is, region 52, by annealing.

However, in the above-mentioned process, the annealing is carried out after a different material from the amorphous Si, that is N⁺ ions, has been implanted, and thus N atoms sometimes remain in the crystalline Si as an impurity. In that case, N atoms act as an electrically active impurity and sometimes inhibit formation of devices of high performance.

A similar process to that just described is disclosed in Japanese Patent Application publication No. 58-085520, wherein oxygen ions instead are implanted and single crystal islands are grown in the regions where oxygen ions are not implanted. In this case oxygen is present as an impurity.

The present invention has therefore been provided as a remedy. In particular it is intended as a process of forming polycrystalline semiconductor thin film having grains at predetermined positions, of a grain size and thickness suitable for forming a thin film transistor.

The process defined in the appended claims is based on a finding that in amorphous semiconductor film, notably in amorphous silicon semiconductor film on quartz or glass, the activation energy required for generating crystal nuclei is greater than the activation energy required for growing single crystal from an existing nucleus, and that these activation energies increase as functions of increasing implanted ion dose. Corresponding to a particular ion dose there is thus an upper temperature limit above which both crystal nucleus generation and crystal growth can be activated readily, and a lower temperature limit below which neither crystal nucleus generation nor crystal growth can be activated readily. If then an ion dose is applied selectively so as to implant the amorphous semiconductor film in a region surrounding nucleation site regions of the film, it is possible to select a first heat treatment temperature which is above the upper temperature limit of the nucleation site regions of the film, while at the same time this temperature is below the higher upper temperature limit of the surrounding region. For such a temperature, crystal nucleus generation will occur in the nucleation sites but not in the surrounding region of the film. If the temperature is then lowered to a temperature below the upper temperature limit of the nucleation site regions to a temperature but which is above the lower temperature limit of the surrounding region, for a second heat treatment, then growth will spread throughout the film while further crystal nucleus generation in the nucleation site regions and initial crystal nucleus generation in the surrounding region of the film is suppressed.

There can be obtained a crystalline semiconductor film the positions of grain boundaries of which are controlled and which has a desired grain size. When a device is formed with the present crystalline semiconductor film, it is possible to form an integrated circuit with good characteristics without any fluctuation even if the number of devices is much larger than the number of devices produced so far.

Furthermore, a flat semiconductor film having a larger grain size can be formed without a polishing step, etc., and thus the process steps for forming devices can be considerably simplified.

Since the implanted ions are of an element constituting the thin film, inclusion of impurities into the crystalline semiconductor film is avoided and a device of very high performance can be formed from the crystalline semiconductor film produced.

The present invention will be explained in detail below together with findings obtained when the present invention was accomplished.

The point of the present invention is how to control the crystal growth positions in an amorphous solid phase, that is, how to preferentially generate nuclei of crystals at specific positions in an amorphous semiconductor film and suppress generation of nuclei in other regions.

In the accompanying drawings:
Figs. 1A to 1B and 2 show process steps for forming a crystalline semiconductor film according to prior art;
Figs. 3A to 3E show process steps according to an embodiment of the present invention;
Fig. 4 is a diagram showing a relationship between heat treatment temperature and a degree of crystallisation of amorphous Si film in relation to Si ion implantation dose;
Fig. 5 is a diagram showing a relationship between heat treatment temperature and density of crystal nuclei formed in an amorphous film;
Fig. 6 is a diagram showing a relationship between ion implantation dose and density of crystal nuclei formed by heat treatment; and
Fig. 7 shows formation steps by heat treatment according to the present invention.

The present invention has been established on the basis of results of extensive experimental studies on the solid phase growth of crystalline semiconductor films in the aforementioned situations as background.

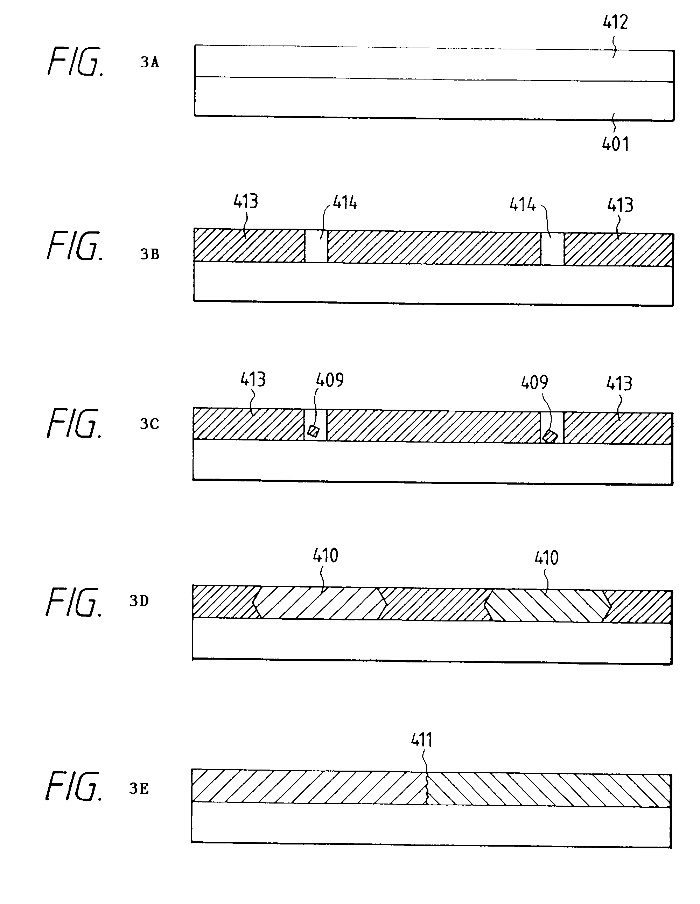

Now, the process for forming a polycrystalline semiconductor film according to the present invention will be explained below, referring to Figs. 3 to 7.
I. At first, the formation and implantation of an amorphous film 412 on a substrate 401 will be explained.
   (1) Substrate 401 is composed of a material that can withstand successive heat treatment steps including those applied during device formation. The substrate may be a quartz substrate, or a glass substrate.
      Then, amorphous silicon film 412 is deposited on the substrate 401 by vacuum vapour deposition with electron beam heating, a reduced pressure CVD method, a plasma CVD method, or by a method of converting a deposited polycrystalline film into an amorphous film by implanting ions of an element constituting the polycrystalline material into the deposited polycrystalline film (Fig. 3A).
   (2) Then, ions of an element constituting the amorphous film 412 are implanted into a region 413 surrounding those regions 414 where formation of nuclei is desired to take place in the amorphous film 412. The ion implantation can be carried out by masking the regions 414 with resist, etc. by patterning masks for ion implantation or by masking according to any other procedure. The size of the regions 414 not subject to the ion implantation is large enough to form only one crystal by heat treatment. The size of regions 414 not subject to the ion implantation depends on the density of crystal nuclei formed by the heat treatment, and is not more than 5 µm in diameter, preferably not more than 2 µm in diameter. Thus it is preferable to control the density of crystal nuclei to obtain the preferable or more preferable size of regions 414 (Fig. 3B).
II. The heat treatment steps will be explained below. The present inventors have found the following facts by experiments on the solid phase crystallisation of amorphous silicon film.
   1. An amorphous silicon film formed by implanting silicon ions into a polycrystalline silicon film having grain sizes of 10 Å (10Å=1nm) to a few hundred Å formed by a reduced pressure CVD method etc. was annealed in a lamp anneal furnace for a long time.

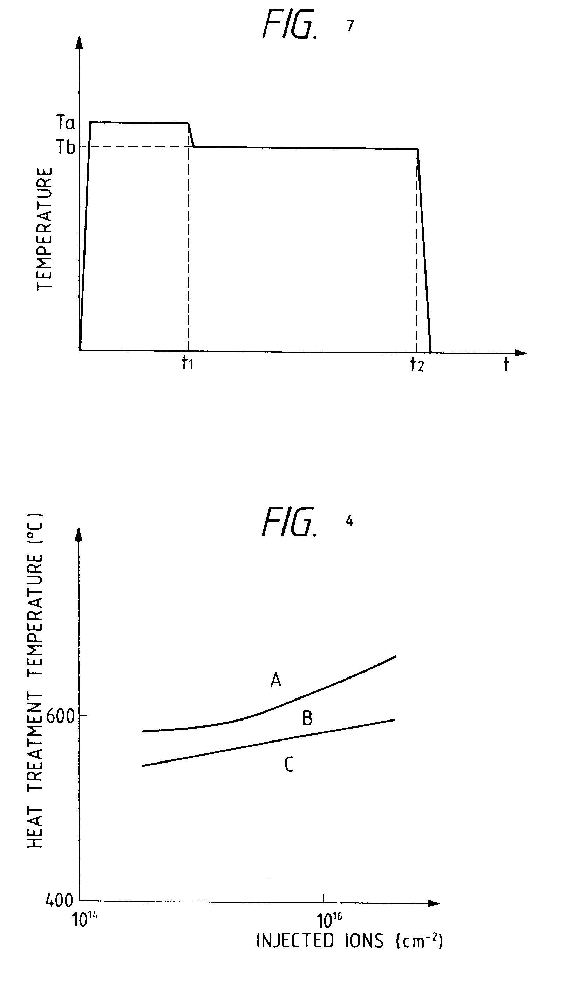

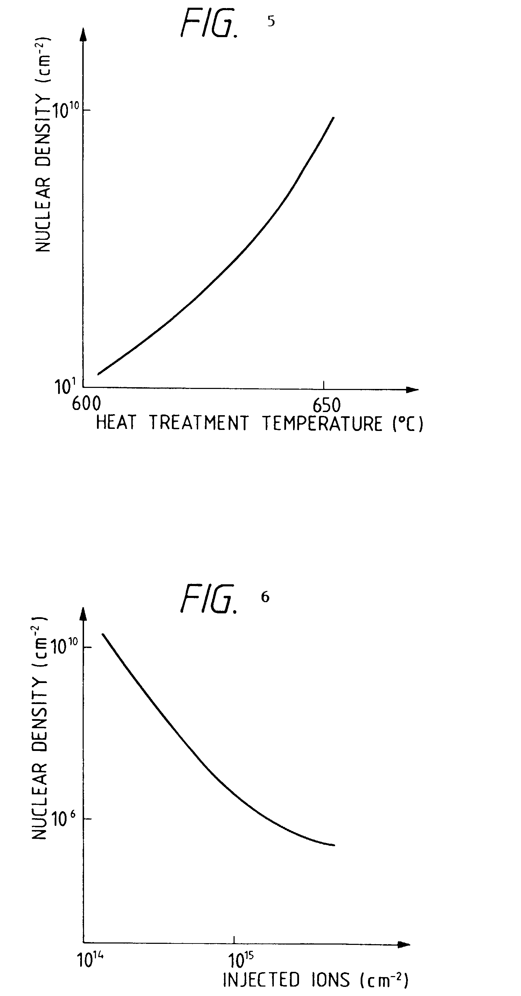

      Fig. 4 is a diagram showing a relationship between heat treatment temperature and the degree of crystallisation of an amorphous silicon film through a Si ion dose, obtained by the annealing. As is obvious from Fig. 4, crystal nuclei were generated at a higher temperature than a critical temperature of about 600°C (Tc) and crystals grow from the crystal nuclei as growth points. In Fig. 4, a zone for such crystal growth is shown by zone A. When the temperature was lower than Tc, no crystals were formed at all even by heat treatment for 200 hours. The generation of crystals was observed by a transmission-type electron microscope. It was found that by providing crystals in the amorphous film in advance or by providing crystals acting as growth points for the solid phase crystal growth in contact with the amorphous film, the crystal growth proceeded as the crystals as growth points even in a zone at a lower temperature than Tc. Such a zone is shown as zone B in Fig. 4. When the temperature was lower than the minimum temperature of zone B, crystal growth did not proceed. Such zone is shown by zone C in Fig. 4.
      It seems that the foregoing phenomena are due to a difference between the activation energy of crystal nucleus growth and that of formation of crystal nuclei. That is, it seems that the activation energy of formation of crystal nuclei is somewhat higher than that of crystal nucleus growth.
   2. Also it was found, as a result of analysis based on the pictures obtained by a transmission-type electron microscope, that the average grain size of crystallised films obtained by annealing at temperature within the zone A of Fig. 4 were decreased with increasing anneal temperature as shown in Fig. 5. Fig. 5 shows a relationship between an anneal temperature and density of nuclei formed in the amorphous film. As is obvious from Fig. 5, the density of nuclei formed in the amorphous film is increased with increasing anneal temperature. This phenomena is based on the fact that the heat energy to be given to the amorphous film is increased with increasing anneal temperature and consequently a frequency to form crystal nuclei is increased.
      Fig. 6 shows a relationship between a density of crystal nuclei generated in an amorphous silicon film and an ion implantation dose to the polycrystalline silicon film by implanting ions into the polycrystalline silicon film, thereby making the polycrystalline silicon film amorphous and then by heat-treating the film. As is obvious from Fig. 6, the density of crystal nuclei is increased also with decreasing silicon ion implantation dose into the polycrystalline silicon film. When the polycrystalline film is made amorphous by the ion implantation, it seems that the degree of residence of long-distance order in the amorphous film depends on an ion implantation dose.

On the basis of the foregoing findings 1 and 2, heat treatment is carried out as shown in Fig. 7.
(1) In heat treatment up to the initial time t₁, a heat treatment temperature is set to Ta only for a predetermined time at the initial stage of crystallisation. In Fig. 7, Ta is a heat treatment temperature within the crystal generation and growth range, i.e. zone A, for the regions 414 not subject to the ion implantation and also within the range of zone B of Fig. 4 for the region 413 subject to the ion implantation. The existence of such a temperature Ta is seen from Figs. 4 and 6. By setting the heat treatment temperature in the above-mentioned manner, the regions where the formation of nuclei takes place are restricted to control the positions of crystal nuclei to be formed in the amorphous film (Fig. 3B). By controlling the heat treatment temperature or the ion implantation dose into the amorphous film, only one crystal nucleus 409 can be formed in each of the desired regions 414. (Fig. 3C).
   Ta is a temperature below the melting point of the amorphous film, at which crystal nuclei can be generated by heat treatment. t₁ is the time required for forming only a single crystal nucleus in each of the regions 414 not subject to the ion implantation, and depends on the conditions of forming the amorphous film, the heat treatment temperature, etc. t₁ is preferably the latent time for the generation of crystal nuclei plus about one to about 5 hours.
(2) The position-controlled crystal nuclei 409, formed during the time t₁ are further subjected to crystal growth after the time t₁. After the time t₁, heat treatment is carried out until time t₂ the crystals 409 are grown to a desired grain size by setting the heat treatment temperature to a temperature Tb within the zone B of Fig. 4 and making the crystals 409 grow as the crystal nuclei growth points, so that no new crystal generation may take place in the amorphous film until the entire amorphous film is crystallised by the crystal growth from the crystal nuclei (Fig. 4D). When the crystal growth is continued until the adjacent crystals are brought into contact with each other, a crystal grain boundary 411 is formed along the line at the middle of the line connecting the two adjacent crystal nuclei as growth points for these crystals. Thus, the position of crystal grain boundary can be controlled thereby.
   In this manner, groups of crystal grains with controlled position and grain size of crystal grains and controlled position of crystal grain boundary can be formed (Fig. 3E).

By arranging the regions 414 not subject to the ion implantation in a lattice point manner as shown in Fig. 3B and making crystal growth, single crystal grains are regularly arranged as shown in Fig. 3E and thus devices containing no crystal grain boundaries inside can be formed readily.

The process for forming a crystalline semiconductor film according to the present invention is explained below, referring to Examples.

### Example 1

At first, an amorphous silicon film was deposited on the surface of a quartz substrate to a thickness of 100 nm at 550°C by a reduced pressure CVD method. At that time, the flow rate of SiH₄ gas was 20 sccm, the reaction pressure was 0.3 Torr (1 Torr = 133.3Pa), and the substrate temperature was 550°C.

Then, a resist mask was provided on the surface of the amorphous silicon film having a lattice dot pattern with square dots 1 µm x 1 µm at distances of 8 µm formed by conventional photolithography.

Si⁺ ions were implanted only into the resistunmasked regions at an implantation energy of 70 keV and a dose of 5 x 10¹⁵ cm⁻². Then, the resist mask was removed.

The substrate was then heat treated in a nitrogen atmosphere at 630°C for 15 hours in a lamp anneal furnace. As the result of observation of the substrate by a transmission-type electron microscope, only one crystal was found in each of the regions not subject to the ion implantation in the amorphous silicon film.

Successive to the above heat treatment, the substrate was further heat treated in a nitrogen atmosphere at 580°C for 100 hours. As the result of observation of the substrate by a transmission-type electron microscope, it was found that in the amorphous silicon film crystals underwent solid phase growth at the Si crystals as growth points and the substrate surface was covered with crystal grains having grain sizes of about 8 µm, and no amorphous regions were observed.

A plurality of n-MOS transistors, 3 µm in channel length and 5 µm wide, were formed on the thus formed silicon polycrystalline film by an ordinary semiconductor process, so that the channel part could be contained in one crystal grain. The source/drain regions were formed by phosphorus implantation. Among them, the mobility (electric field effect mobility) of 100 transistors in the triode tube zone was 190 cm²/V.sec on the average, and the fluctuation in the threshold voltage was about ± 320 mV from the average value. That is, the mobility was higher than a mobility of 110 cm²/V.sec in the MOS transistors (channel length: 10 µm) on a polycrystalline silicon formed by conventional solid phase recrystallisation at a single temperature and the fluctuation in the threshold value was lower than ± 500 mV.

As obvious from the foregoing, the size of crystal grains constituting a polycrystalline film was made uniform, and devices containing no grain boundaries could be made by controlling the positions of crystal grain boundaries. That is, devices with distinguished characteristics could be formed with less differences between the devices.

### Example 2

At first, a polycrystalline film was deposited on a glass substrate to a thickness of about 100 nm by a reduced pressure CVD method using SiH₄. At that time, the flow rate of SiH₄ was 20 sccm, the reaction pressure was 0.3 Torr, and the substrate temperature was 620°C.

Then, Si⁺ ions were implanted on the polycrystalline silicon film at an implantation energy of 25 keV and an ion implantation dose of 5 x 10¹⁵cm⁻² to make the polycrystalline silicon film amorphous.

Then, a resist mask was provided on the surface of the thus formed amorphous silicon film by photolithography in an ordinary semiconductor process having resist mask squares 2 µm x 2 µm in a lattice dot pattern at distances of 10 µm.

Again, Si⁺ ions were implanted only into the unmasked regions at an implantation energy of 70 keV and an ion implantation dose of 5x10¹⁵cm⁻². Then, the resist mask was removed.

Then, the substrate was heat treated in a nitrogen atmosphere at 655°C for 15 hours. As a result of observation of the substrate by an electron microscope, a single crystal was found in each of the regions not subject to the ion implantation in the amorphous silicon thin film.

Successive to the above heat treatment, the substrate was heat treated in a nitrogen atmosphere at 580°C for 120 hours. As a result of observation of the substrate by a transmission-type electron microscope, it was found that in the amorphous silicon film crystals underwent solid phase growth at the Si crystal nuclei as growth points. The substrate surface was covered with crystal grains having grain sizes of about 10 µm, and no amorphous regions were observed.

A plurality of n-MOS transistors, 3 µm in channel length and 5 µm wide, were formed on the thus formed silicon polycrystalline film by an ordinary semiconductor process, so that the channel part could be contained in the single crystal grain. The source drain regions were formed by phosphorus implantation. Among them, the mobility of 100 transistors in the triode tube zone was 200 cm²/V.sec, and the fluctuation in the threshold voltage was about ± 310 mV from the average value. That is, the mobility was higher than a mobility of 110 cm²/V.sec in the MOS transistors (channel length : 10 µm) on a polycrystalline silicon formed by conventional solid phase recrystallisation at a single temperature and the fluctuation in the threshold value was lower than ± 500 mV. That is because the average grain size of grains constituting the crystalline film became larger and the crystalline film could be formed by controlling the positions of grain boundaries.

It follows from the foregoing examples that the present process for forming a crystalline semiconductor film has the following advantages.

A polycrystalline semiconductor film having a desired grain size with controlled positions of crystal grain boundaries can be obtained. When devices are formed with such polycrystalline semiconductor film, an integrated circuit with distinguished characteristics and without fluctuations in the characteristics even if a considerably increased number of devices is formed.

Furthermore, a flat crystalline semiconductor film having a larger grain size can be formed without requiring a polishing step, etc., and thus the process for forming devices can be considerably simplified.

Still furthermore, impurities that contaminate a polycrystalline semiconductor film can be suppressed to a maximum, and thus devices with a very high performance can be formed from such polycrystalline semiconductor film.

## Claims

1. A process of forming a polycrystalline silicon thin film having grains (410) at predetermined positions each of a grain size and thickness suitable for forming a thin film transistor, this process comprising:
providing a quartz or glass substrate (401) having on its surface a thin film (412) of amorphous silicon semiconductor material;
implanting ions of silicon into said thin film (412) except for regions (414) thereof which are at predetermined positions and which are not more than 5 µm in diameter, said regions (414) being spaced apart, in a lattice point manner, each spaced at a distance that is to determine said grain size;
applying a first heat treatment at a first set temperature (Ta) which is below the melting point of said thin film, is in a temperature range (A) for which both crystal generation and growth can occur for said regions (414), and is in a temperature range (B) for which growth and not crystal generation can occur for the ion implanted remainder (413) of said thin film (412), said first heat treatment being applied for a time (t₁)which is the latent time for crystal generation for said silicon semiconductor material of said regions (414) plus one to five hours such that only one crystal nucleus (409) is formed in each of said regions (414); and
applying a second heat treatment at a second and lower set temperature (T_{b}) in a temperature range for which growth and not crystal generation can occur both for said regions (414) and for the ion implanted remainder (413) of said thin film (412), said second heat treatment being applied for a time (t₂) in which adjacent crystal grains (41), grown from the crystal nuclei (409), contact each other (411).

2. A process as claimed in claim 1 wherein the step of providing the substrate (401) having on its surface the thin film (412) of amorphous silicon semiconductor material comprises steps of depositing a polycrystalline thin film of silicon semiconductor material on the surface of said substrate (401) and implanting ions of silicon into said polycrystalline thin film (412) to convert it to said thin film of amorphous silicon semiconductor material.

3. A process as claimed in claim 1 wherein the step of providing the substrate (401) having on its surface the thin film (412) of amorphous silicon semiconductor material comprises depositing said thin film (412) of amorphous silicon semiconductor material on the surface of said substrate (401) by: vacuum vapour deposition with electron beam heating; reduced pressure chemical vapour deposition, or plasma chemical vapour deposition.

4. A process as claimed in any preceding claim including steps of forming thin film transistors in respective grains (410) of the polycrystalline semiconductor thin film.

## Patentansprüche

1. Ein Verfahren zur Herstellung eines polykristallinen Silizium-Dünnfilms mit Körnern (410) an vorbestimmten Stellen, wobei jedes eine für die Herstellung eines Dünnfilm-Transistors geeignete Korngröße und Dicke hat, wobei dieses Verfahren umfaßt:
Bereitstellen eines Quarz- oder Glassubstrates (401) mit einem Dünnfilm (412) aus amorphem Silizium-Halbleitermaterial auf dessen Oberfläche;
Implantieren von Siliziumionen in den Dünnfilm (412) mit Ausnahme von Gebieten (414) davon, die an vorbestimmten Stellen liegen und die nicht mehr als 5 um Durchmesser haben, wobei die Gebiete (414) nach Art von Gitterpunkten voneinander beabstandet sind, wobei jedes in einem Abstand angeordnet ist, der die Korngröße bestimmt;
Durchführen einer ersten Wärmebehandlung bei einer ersten eingestellten Temperatur (Ta), die unterhalb des Schmelzpunktes des Dünnfilms liegt, die sich in einem Temperaturbereich (A) befindet, in dem sowohl Kristallbildung als auch Wachstum in den Gebieten (414) stattfinden können, und die sich in einem Temperaturbereich (B) befindet, in dem Wachstum, nicht aber Kristallbildung für die ionenimplantierten Restbereiche (413) des Dünnfilms (412) stattfinden können, wobei die erste Wärmebehandlung für eine Zeit (t₁) durchgeführt wird, die der um ein bis fünf Stunden erhöhten Latenzzeit für Kristallbildung für das Silizium-Halbleitermaterial der Gebiete (414) entspricht, so daß nur ein Kristallkeim (409) in jedem der Gebiete (414) gebildet wird; und
Durchführen einer zweiten Wärmebehandlung bei einer zweiten, tiefer eingestellten Temperatur (Tb) in einem Temperaturbereich, in dem Wachstum, nicht aber Kristallbildung sowohl für die Gebiete (414) als auch für die ionenimplantierten Restbereiche (413) des Dünnfilms (412) stattfinden können, wobei die zweite Wärmebehandlung für eine Zeit (t₂) durchgeführt wird, in der aus den Kristallkeimen (409) erwachsene, benachbarte Kristallkörner (410) sich gegenseitig berühren (411).

2. Ein Verfahren nach Anspruch 1, bei dem der Schritt des Bereitstellens des Substrates (401) mit einem Dünnfilm (412) aus amorphem Silizium-Halbleitermaterial auf dessen Oberfläche Schritte des Abscheidens eines polykristallinen Dünnfilms aus Silizium-Halbleitermaterial auf der Oberfläche des Substrates (401) und des Implantierens von Siliziumionen in den polykristallinen Dünnfilm (412) umfaßt, um diesen in den Dünnfilm aus amorphen Silizium-Halbleitermaterial umzuwandeln.

3. Ein Verfahren nach Anspruch 1, bei dem der Schritt des Bereitstellens des Substrates (401) mit einem Dünnfilm (412) aus amorphem Silizium-Halbleitermaterial auf dessen Oberfläche das Abscheiden des Dünnfilms aus amorphen Silizium-Halbleitermaterial auf der Oberfläche des Substrates (401) mittels: Vakuum-Gasphasenabscheidung mit Elektronenstrahl-Heizen; chemischer Abscheidung aus der Gasphase bei verringertem Druck oder plasma-chemischer Gasphasenabscheidung umfaßt.

4. Ein Verfahren nach einem der vorstehenden Ansprüche, das Schritte zur Herstellung von Dünnfilm-Transistoren in jeweiligen Körnern (410) des polykristallinen Halbleiter-Dünnfilms umfaßt.

## Revendications

1. Procédé de formation d'un film mince de silicium polycristallin ayant des grains (410) dans des positions déterminées à l'avance présentant chacun une taille et une épaisseur de grains convenant pour la formation d'un transistor à film mince, ce procédé comprenant :
le fait de réaliser un substrat de quartz ou de verre (401) ayant sur sa surface un film mince (412) de matière semi-conductrice de silicium amorphe ;
le fait d'implanter des ions de silicium dans ledit film mince (412) exception faite pour des régions (414) de celui-ci qui sont dans des positions déterminées à l'avance et qui n'ont pas plus de 5 micromètres de diamètre, lesdites régions (414) étant espacées entre elles, à la manière des points d'un réseau, à une distance qui déterminera cette taille de grains ;
le fait d'appliquer un premier traitement par la chaleur à une première température fixée (Ta) qui est inférieure au point de fusion de ce film mince, qui est dans un intervalle de températures (A) pour lequel la formation et la croissance des cristaux peuvent se produire toutes deux pour lesdites régions (414), et qui est dans un intervalle de températures (B) pour lequel la croissance, mais non la formation de cristaux peuvent se produire pour le reste desdits ions implantés (413) dudit film mince (412), ledit premier traitement par la chaleur étant appliqué pendant un temps (t₁) qui est le temps de latence pour la formation de cristaux pour ladite matière semi-conductrice en silicium desdites régions (414) plus 1 à 5 heures, de telle sorte qu'il se forme un seul noyau cristallin (409) dans chacune desdites régions (414) ; et
le fait d'appliquer un second traitement par la chaleur à une seconde température fixée à une valeur inférieure (T_{b}) dans un intervalle de températures pour lequel la croissance et non la formation de cristaux peut se produire tant pour lesdites régions (414) que pour le reste des ions implantés (413) dudit film mince (412), ledit second traitement par la chaleur étant appliqué pendant un temps (t₂) dans lequel des grains cristallins adjacents (41), cultivés à partir des noyaux cristallins (409), viennent au contact les uns des autres (411).

2. Procédé selon la revendication 1, dans lequel l'étape de réalisation du substrat (401) ayant sur sa surface ledit film mince (412) de matière semi-conductrice de silicium amorphe comprend les étapes consistant à déposer un film mince polycristallin de matière semi-conductrice de silicium sur la surface dudit substrat (401) et à implanter des ions silicium dans ledit film mince polycristallin (412) pour le transformer en ce film mince de matière semi-conductrice de silicium amorphe.

3. Procédé selon la revendication 1, dans lequel ladite étape de réalisation dudit substrat (401) ayant sur sa surface ledit film mince (412) de matière semi-conductrice en silicium amorphe comprend le fait de déposer ledit film mince (412) de matière semi-conductrice en silicium amorphe sur la surface dudit substrat (401) par : dépôt sous vide en phase vapeur en chauffant avec un faisceau électronique ; dépôt chimique en phase vapeur sous pression réduite, ou dépôt chimique en phase vapeur dans un plasma.

4. Procédé selon l'une quelconque des revendications précédentes, comprenant les étapes de formation de transistors de film mince dans les grains respectifs (410) dudit film mince de semi-conducteur polycristallin.
